# FASCICULE DE BREVET EUROPEEN

(11) **EP 1 677 347 B1**
(45) Date de publication et mention de la délivrance du brevet: **28.09.2011**
(21) Numéro de dépôt: 05113014.4
(22) Date de dépôt: 28.12.2005
(51) Int. Cl.: H01L 21/8246, H01L 27/22, G11C 11/14

(54) **Mémoire vive magnétique**
Magnetischer Speicher
Magnetic random access memory

(30) Priorité: 30.12.2004 FR 0453261
(43) Date de publication de la demande: 05.07.2006
(73) Titulaire: STMicroelectronics (Rousset) SAS, 13790 Rousset (FR)
(72) Inventeur: Boivin, Philippe, 13770, Venelles (FR)
(74) Mandataire: de Beaumont, Michel

(56) Documents cités:
- US-A1- 2004 027 844
- US-A1- 2004 052 127

## Description

### Domaine de l'invention

La présente invention concerne une mémoire vive magnétique ou MRAM (acronyme anglais pour magnetic ramdom access memory) et un procédé de fabrication d'une telle mémoire.

### Exposé de l'art antérieur

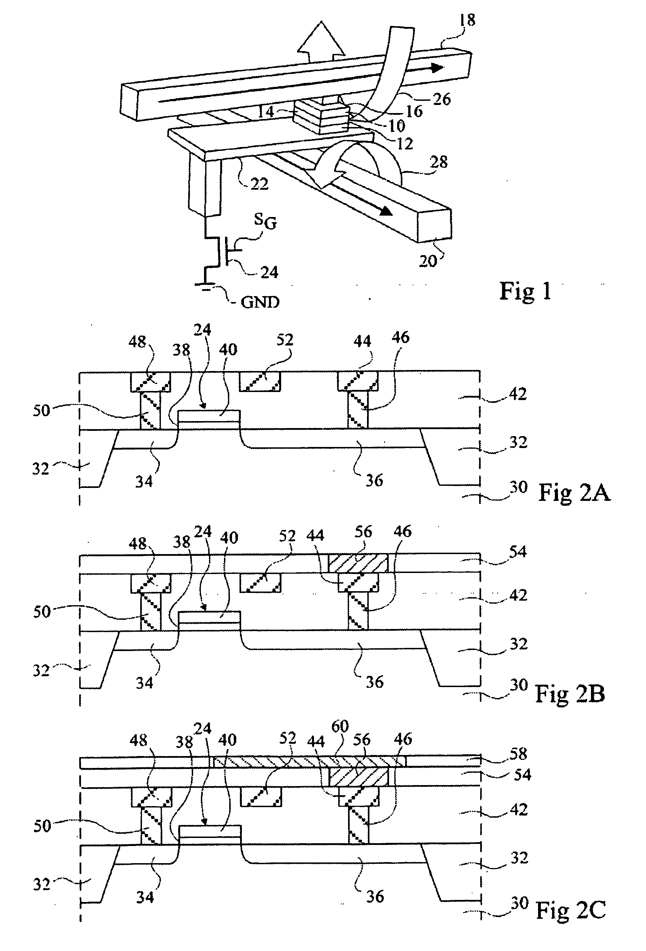

La figure 1 illustre le fonctionnement d'une mémoire vive magnétique. Une telle mémoire comprend une matrice d'éléments mémoire disposés en rangées et en colonnes, un seul élément mémoire 10 étant représenté en figure 1. Chaque élément mémoire 10 est constitué de l'empilement de trois couches : une première couche 12 constituée d'un matériau magnétique, par exemple du cobalt, dont l'orientation magnétique est fixe, une deuxième couche 14 constituée d'un isolant et une troisième couche 16 constituée d'un matériau ferromagnétique, par exemple un alliage de cobalt et de fer ou un alliage de nickel et de fer, dont l'orientation magnétique peut varier. La couche isolante 12 joue le rôle de barrière pour empêcher l'alliage entre la couche magnétique 12 et la couche ferromagnétique 16 et permettre le passage des électrons dont le spin doit être conservé. De façon générale, chaque couche de l'élément mémoire peut elle-même être constituée de plusieurs couches. Tous les éléments mémoire 10 d'une même colonne de la matrice sont connectés à une piste conductrice 18, jouant le rôle de ligne de bits. Une piste conductrice 20 est disposée à l'aplomb des éléments mémoire 10 d'une même rangée de la matrice mais n'est pas en contact électrique avec les éléments mémoire de la rangée.

Pour chaque élément mémoire 10 de la matrice, la première couche 12 est reliée par l'intermédiaire d'une portion de connexion 22 au drain (ou à la source) d'un transistor MOS 24 à canal N ou P dont la source (ou le drain) est reliée à un potentiel de référence, par exemple la masse GND. La grille du transistor MOS 24 est commandée par un signal de commande de grille S_{G}. Le transistor MOS associé à chaque élément mémoire peut être remplacé par un circuit à diode. Le transistor MOS 24 a pour rôle la sélection en lecture de l'élément mémoire 10 à adresser.

A titre d'exemple, la couche magnétique 12 de l'élément mémoire 10 a un vecteur moment magnétique dont l'orientation est fixe quelle que soit l'amplitude du champ magnétique dans lequel baigne l'élément mémoire. La couche ferromagnétique 16 a alors un vecteur moment magnétique dont l'orientation peut être modifiée par l'application d'un champ magnétique. A titre d'exemple, une donnée binaire peut être stockée dans l'élément mémoire en orientant le vecteur moment magnétique de la couche ferromagnétique 16 en parallèle ou en antiparallèle par rapport au vecteur moment magnétique de la couche magnétique 12.

Une opération d'écriture d'une donnée dans l'élément mémoire 10 est réalisée en faisant passer un courant dans la ligne de bits 18 et dans la ligne de mot 20 associées à l'élément mémoire. La circulation d'un courant dans la ligne de bits 18 entraîne la formation d'un champ magnétique dont l'orientation générale des lignes de champ est représentée par la flèche 26. De façon analogue, la circulation d'un courant dans la ligne de mot 20 entraîne la formation d'un champ magnétique dont l'orientation générale des lignes de champ est représentée par la flèche 28. Selon le sens de circulation du courant dans la ligne de bits 18 et la ligne de mot 20, le vecteur moment magnétique de la couche ferromagnétique 16 est orienté en parallèle ou en anti-parallèle par rapport au vecteur moment magnétique de la couche magnétique 12. Pendant une opération d'écriture, le transistor MOS 24 est fermé.

Une opération de lecture de la donnée binaire stockée dans l'élément mémoire 10 est réalisée en ouvrant le transistor 24 associé à l'élément mémoire 10 et en faisant circuler un courant dans celui-ci par l'intermédiaire de la ligne de bits 18. La détermination de la donnée stockée dans l'élément mémoire se base sur la différence de la résistance de l'élément mémoire 10 selon la différence d'orientation des vecteurs moment magnétique de la couche ferromagnétique 16 et de la couche magnétique 12.

Le brevet américain US 2004/0027844 décrit un procédé de fabrication d'une mémoire vive magnétique.

Les figures 2A à 2G représentent des étapes successives d'un exemple classique de procédé de fabrication d'un tel élément mémoire 10 sous forme intégrée. Un tel procédé est notamment décrit dans le brevet américain US 6 673 675.

Comme cela est représenté en figure 2A, la mémoire magnétique est réalisée sur un substrat 30, par exemple en silicium monocristallin, comprenant des tranchées d'isolation 32 isolant les éléments mémoire les uns des autres. Deux régions dopées 34, 36 de type N forment les régions de source et de drain du transistor MOS 24. La grille du transistor MOS 24 est constituée de l'empilement d'une couche d'oxyde de grille 38, par exemple de l'oxyde de silicium, et d'une couche de grille 40, par exemple en silicium polycristallin. Le substrat 30 et la grille du transistor MOS 24 sont recouverts d'une couche isolante 42. Une portion de connexion 44, par exemple métallique, est enterrée en surface de la couche isolante 42 et est reliée à la région dopée 36 par l'intermédiaire d'un contact 46. Une portion de connexion 48, par exemple métallique, est enterrée en surface de la couche isolante 42 et est reliée à la région dopée 34 par l'intermédiaire d'un via 50. La portion de connexion 48 est destinée à être reliée à la masse. Une piste conductrice 52, par exemple métallique, est enterrée en surface de la couche isolante 42 et constitue la ligne de mot 20.

La figure 2B représente la structure obtenue après avoir recouvert la couche isolante 42 d'une couche isolante 54, et formé, dans la couche isolante 54, une portion de connexion 56, par exemple métallique, en contact avec la portion de connexion 44.

La figure 2C représente la structure obtenue après avoir recouvert la couche isolante 54 d'une couche isolante 58 et formé, dans la couche isolante 58, une portion de connexion 60, par exemple métallique, en contact avec la portion de connexion 56 et qui s'étend sensiblement à l'aplomb de la ligne de mot 52.

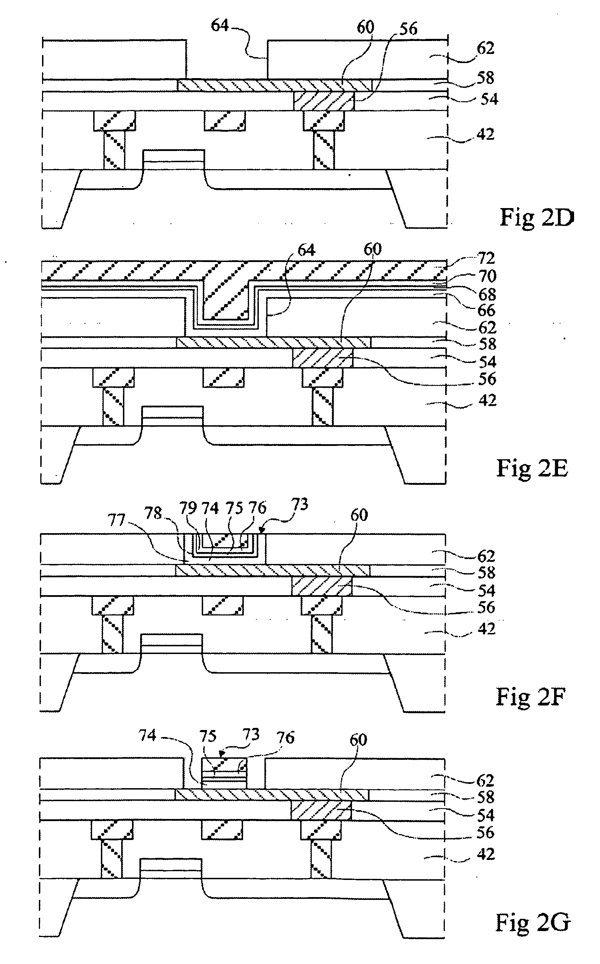

La figure 2D représente la structure obtenue après avoir recouvert la couche isolante 54 d'une couche isolante 62 et gravé un évidement 64 à flancs sensiblement droits dans la couche isolante 54 exposant une partie de la portion de connexion 60.

La figure 2E représente la structure obtenue après avoir déposé, par exemple par dépôt sous phase vapeur ou pulvérisation cathodique, sur la couche isolante 62, une couche magnétique 66, une couche isolante 68, une couche ferromagnétique 70 et une couche conductrice 72, par exemple métallique. Les couches déposées pénètrent dans l'évidement 64 de sorte que la couche magnétique 66 est en contact avec la portion de connexion 60. De façon générale, la couche magnétique 66 a une épaisseur d'environ une dizaine de nanomètres, la couche isolante 68 a une épaisseur de quelques nanomètres, et la couche ferromagnétique 70 a une épaisseur d'une dizaine de nanomètres à quelques dizaines de nanomètres.

La figure 2F représente la structure obtenue après une étape de polissage mécano-chimique (CMP) des couches 66, 68, 70, 72 jusqu'à la couche isolante 62. On isole ainsi un élément mémoire 73 formé de l'empilement de portions magnétique 74, isolante 75 et ferromagnétique 76. Les portions 74, 75, 76 ainsi définies comprennent des zones en coin 77, 78, 79. En d'autres termes, la structure résultante de l'élément mémoire 73 après l'étape de planarisation a une section en "U". De telles zones en coin 77, 78, 79 sont indésirables dans la mesure où il est difficile de maîtriser l'épaisseur de la portion isolante 75 au niveau de la zone en coin 77. En particulier, il y a un risque que l'épaisseur de la portion isolante 75 soit localement diminuée au niveau de la zone en coin 77. Ceci peut entraîner l'apparition de courants de fuite entre la portion magnétique 74 et la portion ferromagnétique 76 dégradant le fonctionnement de l'élément mémoire 73. Il est donc souhaitable d'éliminer les zones en coin 77, 78, 79.

La figure 2G représente la structure obtenue après la gravure des zones en coin 77, 78, 79 de l'élément mémoire 73. On obtient alors un élément mémoire 73 dans lequel les portions magnétique 74, isolante 75 et ferromagnétique 76 sont sensiblement planes.

Un inconvénient est que les matériaux généralement utilisés pour la réalisation des éléments mémoire sont peu réactifs avec les gravures chimiques classiquement utilisées dans les procédés de fabrication de circuit intégré car il n'y a pas de formation de composés volatils. Il est donc nécessaire d'utiliser des gravures de type RIE (acronyme anglais pour reactive ion etching) pour éliminer les zones en coin 77, 78, 79 de l'élément mémoire 73. Un inconvénient de telles gravures est que les matériaux gravés par une gravure de type RIE ont tendance à se redéposer sur les parois de la chambre de gravure et/ou sur d'autres parties du circuit intégré. Il peut en résulter un encrassement de la chambre de gravure, et/ou, ce qui est beaucoup plus gênant, l'apparition de défauts au niveau du circuit intégré.

### Résumé de l'invention

La présente invention vise à obtenir un élément mémoire pour une mémoire vive magnétique ne présentant pas de "zones en coin" et susceptible d'être réalisé par un procédé ne comportant pas d'étapes de gravure de type RIE.

Un autre objet de l'invention est de prévoir un procédé de fabrication d'un tel élément mémoire qui est compatible avec les procédés de fabrication généralement utilisés pour les circuits intégrés.

Un autre objet de l'invention est de prévoir un procédé de fabrication d'un tel élément mémoire qui modifie peu les étapes du procédé de fabrication général de la mémoire vive.

Dans ce but, la présente invention prévoit un élément mémoire pour mémoire vive magnétique, comprenant une première portion magnétique dans un premier évidement d'une première couche isolante ; et une portion non magnétique et une seconde portion magnétique dans un second évidement d'une seconde couche isolante recouvrant la première couche isolante, le second évidement exposant la première portion magnétique et une partie de la première couche isolante autour de la première portion magnétique, la portion non magnétique étant interposée entre les première et seconde portions magnétiques.

Selon un mode de réalisation de la présente invention, la première portion magnétique est connectée à une région de source ou de drain d'un transistor à effet de champ.

La présente invention prévoit également une mémoire vive magnétique comprenant une matrice d'éléments mémoire, tels que décrits précédemment, répartis en rangées et en colonnes, et comprenant, pour chaque rangée, une piste conductrice s'étendant le long de la rangée et destinée à l'écriture de données dans les éléments mémoire de la rangée, les éléments mémoire de la rangée étant disposés à l'aplomb de la piste conductrice avec interposition d'une couche isolante.

La présente invention prévoit également une mémoire vive magnétique comprenant une matrice d'éléments mémoire, tels que décrits précédemment, répartis en rangées et en colonnes, et comprenant, pour chaque rangée, deux pistes conductrices s'étendant le long de la rangée et destinées à l'écriture de données dans les éléments mémoire de la rangée, les éléments mémoire de la rangée étant disposés au niveau du plan équidistant aux deux pistes conductrices.

La présente invention prévoit également un procédé de fabrication d'un élément mémoire magnétique comprenant les étapes consistant à creuser un premier évidement dans une première couche isolante ; à former une première couche magnétique dans le premier évidement et sur la première couche isolante ; à graver, par polissage mécano-chimique, la première couche magnétique et une partie de la première couche isolante pour délimiter une première portion magnétique dans le premier évidement ; à former une seconde couche isolante ; à creuser un second évidement dans la seconde couche isolante exposant la première portion magnétique et une partie de la première couche isolante autour de la première portion magnétique ; à former une couche non magnétique et une seconde couche magnétique dans le second évidement et sur la seconde couche isolante ; et à graver, par polissage mécano-chimique, la seconde couche magnétique, la couche non magnétique, et une partie de la seconde couche isolante pour délimiter une portion non magnétique et une seconde portion magnétique dans le second évidement.

Selon un mode de réalisation de la présente invention, le procédé comprend les étapes préalables consistant à prévoir un substrat de silicium au niveau duquel est formée une région dopée ; à former une couche isolante ; à former une portion de connexion intermédiaire connectée avec la région dopée et une piste conductrice adjacente à la portion de connexion, la piste conductrice étant destinée à l'écriture de données dans l'élément mémoire ; à former une couche isolante ; à former une portion de connexion en contact avec la portion de connexion intermédiaire et surplombant la piste conductrice ; et à former ledit élément mémoire à l'aplomb de la piste conductrice, la première portion magnétique étant connectée à la portion de connexion.

Selon un mode de réalisation de la présente invention, le procédé comprend les étapes préalables consistant à prévoir un substrat de silicium au niveau duquel est formée une région dopée ; à former une couche isolante ; à former une portion de connexion connectée à la région dopée et deux pistes conductrices de part et d'autre de la portion de connexion, les deux pistes conductrices étant destinées à l'écriture de données dans l'élément mémoire ; et à former ledit élément mémoire au niveau du plan équidistant aux deux pistes conductrices, la première portion magnétique étant connectée à la piste de connexion.

### Brève description des dessins

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
la figure 1, précédemment décrite, illustre le fonctionnement d'une mémoire vive magnétique ;
les figures 2A à 2G, précédemment décrites, illustrent des étapes successives d'un exemple de procédé classique de fabrication d'un élément mémoire d'une mémoire vive magnétique ;
les figures 3A à 3E illustrent des étapes successives d'un premier exemple de procédé de fabrication selon l'invention d'un élément mémoire d'une mémoire vive magnétique ; et
les figures 4A à 4D illustrent des étapes d'un second exemple de procédé de fabrication selon l'invention d'un élément mémoire d'une mémoire vive magnétique.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

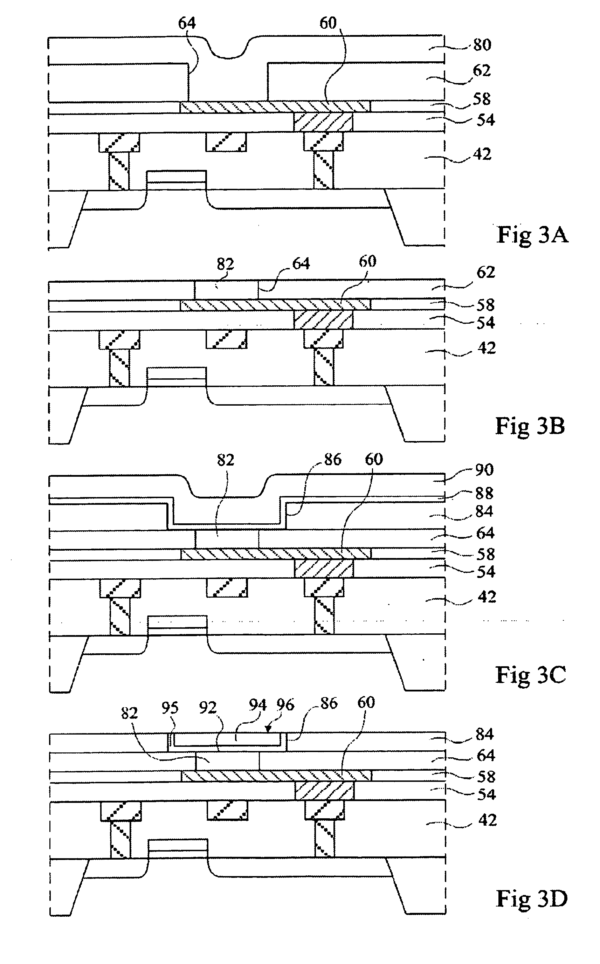

Un premier exemple de procédé de fabrication selon l'invention d'un élément mémoire d'une mémoire vive magnétique va maintenant être décrit en relation aux figures 3A à 3E. Les étapes initiales du premier exemple de procédé correspondent aux étapes précédemment décrites en relation aux figures 2A à 2D.

La figure 3A représente la structure obtenue après avoir déposé, par exemple par dépôt sous phase vapeur, une couche 80 d'un matériau magnétique, par exemple du cobalt, sur la couche isolante 62 et dans l'évidement 64. La couche magnétique 80 pénètre dans l'évidement 64 de façon à être en contact avec la portion de connexion 60. Selon une variante de l'invention, les couches isolantes 58 et 62 correspondent à une seule couche isolante qui est déposée après formation de la portion de connexion 60.

La figure 3B représente la structure obtenue après une étape de polissage mécano-chimique de la couche magnétique 80 et d'une partie de la couche isolante 62 pour délimiter une portion magnétique 82 au niveau de l'évidement 64.

La figure 3C représente la structure obtenue après une étape de dépôt d'une couche isolante 84 sur la structure de la figure 3B, de gravure d'un évidement 86 dans la couche isolante 84, de façon à exposer la totalité de la portion magnétique 82 et une partie de la couche isolante 64 entourant la portion magnétique 82, et de dépôts successifs, par exemple par dépôt sous phase vapeur, d'une couche d'oxyde 88 et d'une couche d'un matériau ferromagnétique 90, par exemple un alliage de cobalt et de fer ou un alliage de nickel et de fer, sur la couche isolante 84 et dans l'évidement 86.

La figure 3D représente la structure obtenue après une étape de gravure par polissage mécano-chimique des couches ferromagnétique 90 et d'oxyde 89 et d'une partie de la couche isolante 84 de façon à délimiter au niveau de l'évidement 86 une portion d'oxyde 92 et une portion ferromagnétique 94. On obtient ainsi un élément mémoire 96 comprenant une zone en "coin" 95 au niveau de la périphérie de la portion d'oxyde 92.

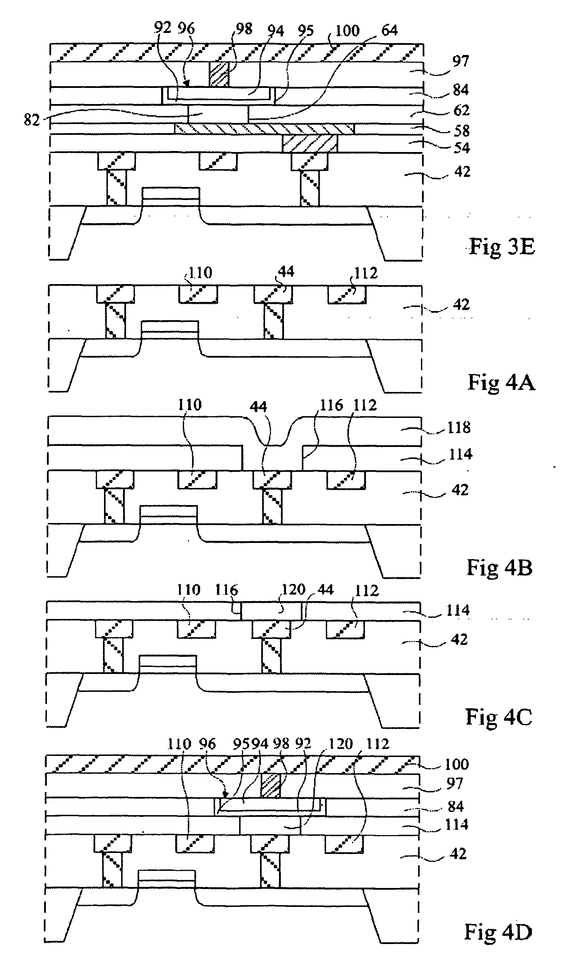

La figure 3E représente la structure obtenue après une étape dans laquelle on a recouvert la couche isolante 84 d'une couche isolante 97, réalisé un via 98, dans la couche isolante 97, venant au contact de la portion ferromagnétique 94 et formé une piste conductrice 100 sur la couche isolante 97 en contact avec le via 98. La piste conductrice 100 correspond à la ligne de bits associée à la colonne de la mémoire vive magnétique à laquelle appartient l'élément mémoire 96.

Selon une variante de l'invention, on dépose une couche métallique au dessus de la couche ferromagnétique 90. Après l'étape de gravure, précédemment décrite en relation à la figure 3D, on délimite alors une portion métallique au niveau de la portion ferromagnétique 94. Le via 98 est alors formé au contact de la portion métallique.

La région "active" de l'élément mémoire 96 correspond à la région de la portion d'oxyde 92 pour laquelle les portions magnétique 82 et ferromagnétique 94 sont en vis-à-vis. La zone en coin 95 de la portion d'oxyde 92 n'est pas gênante dans la mesure où elle ne se situe pas au niveau de la région active de l'élément mémoire 96. Une diminution locale de l'épaisseur de la portion d'oxyde 92 au niveau de la zone en coin 95 ne perturbe donc pas le fonctionnement de l'élément mémoire 96. En outre, le présent procédé de fabrication ne comporte pas d'étapes de gravure de type RIE puisque l'élément mémoire 96 est délimité uniquement par des étapes de polissage mécano-chimique. De ce fait, on évite le risque de dépôt incontrôlé des matériaux constituant l'élément mémoire dans la chambre de gravure ou sur le circuit intégré, caractéristique d'une gravure de type RIE.

Un second exemple de procédé de fabrication selon l'invention d'un élément mémoire d'une mémoire magnétique va maintenant être décrit en relation aux figures 4A à 4D.

La figure 4A représente une structure analogue à la figure 2A. Toutefois, à la différence de la structure représentée en figure 2A, on prévoit, pour chaque rangée de la mémoire vive magnétique, deux pistes conductrices 110, 112 correspondant à deux lignes de mot. Pour chaque élément mémoire d'une même rangée, les pistes conductrices 110, 112 s'étendent de part et d'autre de la portion de connexion 44.

La figure 4B représente la structure obtenue après le dépôt d'une couche isolante 114 sur la couche isolante 42, la gravure d'un évidement 116 dans la couche isolante 42 qui expose la portion de connexion 44, et le dépôt d'une couche d'un matériau magnétique 118, par exemple à base de cobalt, sur la couche isolante 114. La couche magnétique 118 pénètre dans l'évidement 116 pour venir en contact avec la portion de connexion 44.

La figure 4C représente la structure obtenue après une étape de polissage mécano-chimique de la couche magnétique 118 et d'une partie de la couche isolante 114 de façon à délimiter une portion magnétique 120 dans l'évidement 116.

La figure 4D représente la structure obtenue après la mise en oeuvre d'étapes similaires à celles illustrées en relation aux figures 3C et 3D du premier exemple de réalisation.

La structure de l'élément mémoire 96 obtenu par le second exemple de procédé de fabrication selon l'invention est identique à celle obtenue par le premier exemple de procédé de fabrication selon l'invention. En particulier, la zone en coin 95 de la portion d'oxyde 92 est isolée de la région active de l'élément mémoire 96 et n'en perturbe pas le fonctionnement.

Une opération d'écriture d'une donnée dans l'élément mémoire 96 est réalisée en faisant circuler un courant dans la ligne de bits et des courants de sens opposés dans les lignes de mot 110, 112. On obtient alors un champ magnétique dont l'amplitude est maximale sensiblement au niveau d'un plan équidistant aux lignes de mot 110, 112, c'est-à-dire sensiblement au niveau de l'élément mémoire magnétique 96.

Dans le premier exemple de réalisation dans lequel une seule ligne de mot 52 est associée à chaque rangée de la mémoire vive magnétique, il est nécessaire que l'élément mémoire 96 soit disposé à l'aplomb de la ligne de mot 52 pour bénéficier d'un champ magnétique d'amplitude maximale lors d'une opération d'écriture. Dans le second exemple de procédé, le champ magnétique a une amplitude maximale au niveau du plan équidistant aux deux lignes de mot 110, 112. Ceci permet de laisser l'élément mémoire 96 à l'aplomb de la portion de connexion 44. Il n'est alors plus nécessaire de prévoir les étapes de dépôt des couches isolantes 54 et 58 et les étapes de formation des portions de connexion 56 et 60 du premier exemple de procédé. Le second exemple de procédé permet donc de réduire le nombre de masques à prévoir pour la fabrication de l'élément mémoire.

Selon une variante des exemples de réalisation précédemment décrits, le transistor MOS associé à chaque élément mémoire et utilisé pour la lecture de la donnée stockée au niveau de l'élément mémoire peut être remplacé par un circuit à diode.

Selon une autre variante des exemples de réalisation précédemment décrits, une seule ligne de mot est associée à chaque rangée de la mémoire vive magnétique et est connectée à tous les éléments mémoire de la rangée. Chaque élément mémoire est alors pris en sandwich entre la ligne de bits et la ligne de mot associées à l'élément mémoire. Une opération de lecture de la donnée stockée au niveau d'un élément mémoire est alors réalisée en faisant passer un courant dans l'élément mémoire par l'intermédiaire de la ligne de bits et de la ligne de mot associées à l'élément mémoire. Une telle variante de réalisation permet de supprimer le transistor MOS associé à chaque élément mémoire.

La présente invention comporte de nombreux avantages :
Premièrement, elle permet l'obtention d'une mémoire vive magnétique pour laquelle, au niveau de la région active de chaque élément mémoire, l'épaisseur de la portion d'oxyde est relativement uniforme.
Deuxièmement, les étapes du procédé de fabrication de chaque élément mémoire selon l'invention relatives à la gravure des matériaux constituant l'élément mémoire ne mettent en oeuvre que des étapes de polissage mécano-chimique au lieu de gravures de type RIE. Les inconvénients des gravures de type RIE sont ainsi évités.
Troisièmement, le procédé de fabrication selon l'invention met seulement en oeuvre des étapes de dépôt de couches et de gravure par polissage mécano-chimique qui sont compatibles avec les procédés de fabrication habituels de circuit intégré.
Quatrièmement, le procédé de fabrication selon l'invention ne comprend qu'un nombre réduit d'étapes supplémentaires et modifie donc peu les procédés de fabrication habituels de mémoire vive magnétique.

Bien entendu, la présente invention est susceptible de diverses variantes et modifications qui apparaîtront à l'homme de l'art. En particulier, la couche magnétique, la couche d'oxyde et la couche ferromagnétique à partir desquelles est formé l'élément mémoire peuvent chacune être constituées de l'empilement de plusieurs couches.

## Revendications

1. Elément mémoire (96) pour mémoire vive magnétique, comprenant une première portion magnétique (82 ; 120), une seconde portion magnétique (94) et une portion non magnétique (92) interposée entre les première et seconde portions magnétiques, **caractérisé en ce que** :
la première portion magnétique (82 ; 120) est disposée dans un premier évidement (64) d'une première couche isolante (62) ; et
la portion non magnétique (92) et la seconde portion magnétique (94) sont disposées dans un second évidement (86) d'une seconde couche isolante (84) recouvrant la première couche isolante, le second évidement exposant la première portion magnétique et une partie de la première couche isolante autour de la première portion magnétique.

2. Elément mémoire selon la revendication 1, dans lequel la première portion magnétique (82 ; 120) est connectée à une région de source ou de drain (36) d'un transistor à effet de champ (24).

3. Mémoire vive magnétique comprenant une matrice d'éléments mémoire (96) selon la revendication 1 répartis en rangées et en colonnes, et comprenant, pour chaque rangée, une piste conductrice (52) s'étendant le long de la rangée et destinée à l'écriture de données dans les éléments mémoire de la rangée, les éléments mémoire de la rangée étant disposés à l'aplomb de la piste conductrice avec interposition d'une couche isolante (54, 58).

4. Mémoire vive magnétique comprenant une matrice d'éléments mémoire (96) selon la revendication 1 répartis en rangées et en colonnes, et comprenant, pour chaque rangée, deux pistes conductrices (110, 112) s'étendant le long de la rangée et destinées à l'écriture de données dans les éléments mémoire de la rangée, les éléments mémoire de la rangée étant disposés au niveau du plan équidistant aux deux pistes conductrices.

5. Procédé de fabrication d'un élément mémoire magnétique (96) comportant une première portion magnétique (82 ; 120), une seconde portion magnétique (94) et une portion non magnétique (92) interposée entre les première et seconde portions magnétiques, **caractérisé en ce qu'**il comporte les étapes suivantes :
creuser un premier évidement (64) dans une première couche isolante (62) ;
former une première couche magnétique (80) dans le premier évidement et sur la première couche isolante ;
graver, par polissage mécano-chimique, la première couche magnétique et une partie de la première couche isolante pour délimiter la première portion magnétique (82; 120) dans le premier évidement ;
former une seconde couche isolante (84) ;
creuser un second évidement (86) dans la seconde couche isolante exposant la première portion magnétique et une partie de la première couche isolante autour de la première portion magnétique ;
former une couche non magnétique (88) et une seconde couche magnétique (90) dans le second évidement et sur la seconde couche isolante ; et
graver, par polissage mécano-chimique, la seconde couche magnétique, la couche non magnétique, et une partie de la seconde couche isolante pour délimiter la portion non magnétique (92) et la seconde portion magnétique (94) dans le second évidement.

6. Procédé selon la revendication 5, comprenant les étapes préalables suivantes :
prévoir un substrat de silicium (30) au niveau duquel est formée une région dopée (36) ;
former une couche isolante (42) ;
former une portion de connexion intermédiaire (44) connectée avec la région dopée et une piste conductrice (52) adjacente à la portion de connexion, la piste conductrice étant destinée à l'écriture de données dans l'élément mémoire ;
former une couche isolante (54) ;
former une portion de connexion (60) en contact avec la portion de connexion intermédiaire et surplombant la piste conductrice ; et
former ledit élément mémoire (96) à l'aplomb de la piste conductrice, la première portion magnétique (82) étant connectée à la portion de connexion.

7. Procédé selon la revendication 5, comprenant les étapes préalables suivantes :
prévoir un substrat de silicium (30) au niveau duquel est formée une région dopée (36) ;
former une couche isolante (54) ;
former une portion de connexion (44) connectée à la région dopée et deux pistes conductrices (110, 112) de part et d'autre de la portion de connexion, les deux pistes conductrices étant destinées à l'écriture de données dans l'élément mémoire ; et
former ledit élément mémoire (96) au niveau du plan équidistant aux deux pistes conductrices, la première portion magnétique (120) étant connectée à la piste de connexion.

## Claims

1. A memory element (96) for a magnetic RAM, comprising a first magnetic portion (82; 120), a second magnetic portion (94) and a non-magnetic portion (92) interposed between the first and second magnetic portions, **characterized in that**:
the first magnetic portion (82; 120) is arranged in a first recess (64) of a first insulating layer (62); and
the non-magnetic portion (92) and the second magnetic portion (94) are arranged in a second recess (86) of a second insulating layer (84) covering the first insulating layer, the second recess exposing the first magnetic portion and a portion of the first insulating layer around the first magnetic portion.

2. The memory element of claim 1, wherein the first magnetic portion (82; 120) is connected to a source or drain region (36) of a field-effect transistor (24).

3. A magnetic RAM comprising an array of memory elements (96) according to claim 1 distributed in rows and columns, and comprising, for each row, a conductive track (52) extending along the row and intended for the writing of data into the memory elements of the row, the memory elements of the row being arranged above the conductive track with an interposed insulating layer (54, 58).

4. A magnetic RAM comprising an array of memory elements (96) according to claim 1 distributed in rows and columns, and comprising, for each row, two conductive tracks (110, 112) extending along the row and intended for the writing of data into the memory elements of the row, the memory elements of the row being arranged at the level of the plane equidistant from the two conductive tracks.

5. A method for manufacturing a magnetic memory element (96) comprising a first magnetic portion (82; 120), a second magnetic portion (94) and a non-magnetic portion (92) interposed between the first and second magnetic portions, **characterized in that** it comprises the steps of:
digging a first recess (64) into a first insulating layer (62);
forming a first magnetic layer (80) in the first recess and on the first insulating layer;
etching, by chem/mech polishing, the first magnetic layer and a portion of the first insulating layer to delimit the first magnetic portion (82; 120) in the first recess;
forming a second insulating layer (84);
digging a second recess (86) into the second insulating layer exposing the first magnetic portion and a portion of the first insulating layer around the first magnetic portion;
forming a non-magnetic layer (88) and a second magnetic layer (90) in the second recess and on the second insulating layer; and
etching, by chem/mech polishing, the second magnetic layer, the non-magnetic layer, and a portion of the second insulating layer to delimit the non-magnetic portion (92) and the second magnetic portion (94) in the second recess.

6. The method of claim 5, comprising the previous steps of:
providing a silicon substrate (30) at the level of which is formed a doped region (36);
forming an insulating layer (42);
forming an intermediary connection portion (44) connected to the doped region and a conductive track (52) adjacent to the connection portion, the conductive track being intended for the writing of data into the memory element;
forming an insulating layer (54);
forming a connection portion (60) in contact with the intermediary connection portion and overhanging the conductive track; and
forming said memory element (96) above the conductive track, the first magnetic portion (82) being connected to the connection portion.

7. The method of claim 5, comprising the previous steps of:
providing a silicon substrate (30) at the level of which is formed a doped region (36);
forming an insulating layer (54);
forming a connection portion (44) connected to the doped region and two conductive tracks (110, 112) on either side of the connection portion, the two conductive tracks being intended for the writing of data into the memory element; and
forming said memory element (96) at the level of the plane equidistant from the two conductive tracks, the first magnetic portion (120) being connected to the connection track.

## Patentansprüche

1. Ein Speicherelement (96) für ein magnetisches RAM, wobei Folgendes vorgesehen ist: ein erster Magnetteil (82; 120), ein zweiter Magnetteil (94) und ein nicht-magnetischer Teil (92), angeordnet zwischen dem ersten und zweiten Magnetteilen, **dadurch gekennzeichnet, dass**:
der erste Magnetteil (82; 120) in einer ersten Ausnehmung (64) einer ersten Isolierschicht (62) angeordnet ist; und
dass der zweite nicht-magnetische Teil (92) und der zweite Magnetteil (94) in einer zweiten Ausnehmung (86) einer zweiten Isolierschicht (84) angeordnet sind, die die erste Isolierschicht abdeckt, wobei die zweite Ausnehmung den ersten Magnetteil freilegt und einen Teil der ersten Isolierschicht um den ersten Magnetteil herum.

2. Speicherelement nach Anspruch 1, wobei der erste Magnetteil (82; 120) mit einer Source- oder Drain-Region (36) eines Feldeffekt-Transistors (24) verbunden ist.

3. Ein magnetisches RAM, welches Folgendes aufweist: eine Anordnung von Speicherelementen (96) gemäß Anspruch 1 und zwar verteilt in Zeilen und Spalten und für jede Zeile Folgendes aufweisend: eine leitende Bahn (52), die sich entlang der Zeile erstreckt und vorgesehen ist für das Einschreiben von Daten in die Speicherelemente der Zeile, wobei die Speicherelemente der Zeile oberhalb der leitenden Bahn angeordnet sind und zwar mit einer dazwischen angeordneten Isolierschicht (54, 58).

4. Ein magnetisches RAM, das eine Anordnung von Speicherelemente (96) gemäß Anspruch 1 aufweist und zwar verteilt in Zeilen und Spalten und für jeden Zeile zwei leitende Bahnen (110, 112) aufweisend und zwar entlang der Zeile und vorgesehen für das Einschrieben von Daten in die Speicherelemente der Zeile, wobei die Speicherelemente der Zeile auf dem Niveau der Ebene äquidistant von den zwei leitenden Bahnen angeordnet sind.

5. Ein Verfahren zur Herstellung eines Magnetspeicherelements (96) welches Folgendes aufweist: einen ersten Magnetteil (82; 120), einen zweiten Magnetteil (94) und einen nicht-magnetischen Teil (92), angeordnet zwischen den ersten und zweiten Magnetteilen, **dadurch gekennzeichnet, dass** die folgende Schritte vorgesehen sind:
Graben einer ersten Ausnehmung (64) in die erste Isolierschicht (62);
Formen einer ersten Magnetschicht (80) in der ersten Ausnehmung und auf der ersten Isolierschicht;
Ätzen durch chemisch/mechanisches Polieren der ersten Magnetschicht und eines Teils der ersten Isolierschicht, um den ersten Magnetteil (82; 120) in der ersten Ausnehmung zu begrenzen;
Formen einer zweiten Isolierschicht (84);
Graben einer zweiten Ausnehmung (86) in die zweite Isolierschicht und zwar den ersten Magnetteil freilegend und einen Teil der ersten Isolierschicht um den ersten Magnetteil herum;
Formen einer nicht-magnetischen Schicht (88) und einer zweiten Magnetschicht (90) in der zweiten Ausnehmung und auf der zweiten Isolierschicht; und
Ätzen durch chemisch/mechanisches Polieren der zweiten Magnetschicht, der nicht-magnetischen Schicht und eines Teils der zweiten Isolierschicht zur Begrenzung des nicht-magnetischen Teils (92) und des magnetischen Teils (94) in der zweiten Ausnehmung.

6. Verfahren nach Anspruch 5, wobei zuvor die folgenden Schritte ausgeführt werden:
Vorsehen eines Siliziumsubstrats (30) auf dem Niveau auf dem eine dotierte Region (36) geformt wird;
Formen einer Isolierschicht (42);
Formen eines Zwischenverbindungsteils (44), verbunden mit der dotierten Region und einer leitenden Bahn (52), benachbart zu dem Verbindungsteil, wobei die leitende Bahn zum Einschreiben von Daten in das Speicherelement vorgesehen ist;
Formen einer Isolierschicht (54);
Formen eines Verbindungsteils (60) in Kontakt mit dem Zwischenverbindungsteil und über die leitende Bahn hängend; und
Formen des erwähnten Speicherelements (96) oberhalb der leitenden Bahn, wobei der erste Magnetteil (82) mit dem Verbindungsteil verbunden ist.

7. Verfahren nach Anspruch 5, wobei zuvor die folgenden Schritte vorgesehen sind:
Vorsehen eines Siliziumsubstrats (30) auf dem Niveau auf dem eine dotierte Region (36) gebildet ist;
Formen einer Isolierschicht (54);
Formen eines Verbindungsteils (44), verbunden mit der dotierten Region und zwei leitende Bahnen (110, 112) auf jeder Seite des Verbindungsteils, wobei die zwei leitenden Bahnen vorgesehen sind für das Einschreiben von Daten in das Speicherelement; und
Formen des Speicherelements (96) auf dem Niveau der Ebene mit gleichem Abstand gegenüber den zwei leitenden Bahnen, wobei der erste Magnetteil (120) mit der Verbindungsbahn verbunden ist.
